# FASCICULE DE BREVET EUROPEEN

(11) **EP 3 840 557 B1**
(45) Date de publication et mention de la délivrance du brevet: **08.11.2023**
(21) Numéro de dépôt: 20211828.7
(22) Date de dépôt: 04.12.2020
(51) Int. Cl.: H05K 7/14, H05K 7/20

(54) **EQUIPEMENT ELECTRIQUE COMPRENANT UNE BARRE DE CONNEXION ELECTRIQUE REFROIDIE PAR DEUX FACES D'UN DISSIPATEUR THERMIQUE**
ELEKTRISCHES GERÄT MIT EINER ELEKTRISCHEN ANSCHLUSSLEISTE, DIE VON ZWEI SEITEN EINES KÜHLKÖRPERS GEKÜHLT WIRD
ELECTRICAL EQUIPMENT COMPRISING AN ELECTRICAL CONNECTION BAR COOLED BY TWO SURFACES OF A HEAT SINK

(30) Priorité: 18.12.2019 FR 1914810
(43) Date de publication de la demande: 23.06.2021
(73) Titulaire: Valeo eAutomotive France SAS, 95800 Cergy (FR)
(72) Inventeur: LEGENDRE, Alexandre, 95280 JOUY-LE-MOUTIER (FR); POUILLY, Aurélien, 78300 POISSY (FR)
(74) Mandataire: Valeo Powertrain Systems

(56) Documents cités:
- WO-A1-2013/136877
- US-A- 5 574 312
- US-A1- 2004 256 710
- US-A1- 2006 207 780
- US-A1- 2014 062 210

## Description

### DOMAINE TECHNIQUE

La présente invention se rapporte au domaine des équipements électriques, en particulier pour véhicules électriques ou hybrides, et concerne plus précisément le refroidissement des systèmes électriques tels que des onduleurs reliés au moteur dans des systèmes de motorisation électrique.

### ARRIÈRE-PLAN TECHNOLOGIQUE

Il est connu d'utiliser un équipement électrique ayant des barres de connexion électrique, appelées busbar en anglais. Notamment, de telles barres de connexion électrique sont destinées à acheminer une énergie électrique depuis une interface, notamment une interface externe, de l'équipement électrique vers un composant interne de l'équipement électrique. Par exemple, la barre de connexion électrique connecte une borne de l'équipement électrique avec une capacité de l'équipement électrique. La barre de connexion électrique comprend généralement une barre conductrice électrique, notamment métallique, maintenue par un corps en matériau isolant électrique, notamment plastique. Des composants électriques peuvent être reçus sur la barre de connexion électrique pour permettre un filtrage du signal circulant dans la barre conductrice électrique. Lors du passage du courant dans la barre de connexion électrique, la chaleur dégagée par le conducteur électrique et/ou les composants de filtrage peut endommager les autres composants de l'équipement électrique, notamment la capacité, qui génère déjà de la chaleur par effet joule du fait de son propre fonctionnement.

Pour refroidir les barres de connexion électrique, il est connu de les faire passer le long d'une boîte de refroidissement pourvue d'un système de circulation d'un liquide de refroidissement. Cependant, cela peut se révéler insuffisant, notamment lorsque l'équipement électrique opère à haute tension, c'est-à-dire à une tension supérieure à 60V, voire à 80V ou 100V ou 400V ou 800V. En particulier, l'équipement électrique peut fonctionner entre 50kW et 300kW.

Le document WO 2013/136877 A1 décrit un équipement électrique selon l'état de l'art, dans lequel est prévu un dissipateur thermique ayant deux faces opposées, et une barre de connexion électrique venant contre une face du dissipateur thermique pour être refroidie par ce dernier. D'autres composants électriques sont disposés du côté opposé du dissipateur thermique.

Il est donc recherché une solution de refroidissement permettant une dissipation thermique améliorée des barres de conduction électrique.

### RÉSUMÉ DE L'INVENTION

À cet effet, il est proposé un équipement électrique comportant :
- un dissipateur thermique comprenant un volume interne délimité par au moins deux faces opposées,
- une barre de connexion électrique,
la barre de connexion électrique venant contre lesdites deux faces opposées du dissipateur thermique de manière à être refroidie par le dissipateur thermique.

La barre de connexion électrique est donc refroidie par les deux faces opposées du dissipateur thermique. Dans l'art antérieur, seule une face du dissipateur thermique est utilisée pour refroidir la barre de connexion électrique. Ainsi grâce à l'intégration de la barre de connexion électrique avec le dissipateur thermique, le refroidissement de la barre de connexion électrique est augmenté par rapport à l'art antérieur. Notamment, ladite barre de connexion électrique s'étend le long et vient en contact direct avec lesdites deux faces opposées du dissipateur thermique, ou vient contre les faces opposées du dissipateur thermique via une ou plusieurs couches intermédiaires.

Selon un mode de réalisation, la barre de connexion électrique s'étend le long des deux faces opposées de manière à entourer le dissipateur thermique.

Selon un mode de réalisation, le dissipateur thermique comprend un premier côté au niveau duquel lesdites deux faces opposées sont reliées, ladite barre de connexion électrique s'étendant le long dudit dissipateur thermique depuis le premier côté en revenant audit premier côté.

Dans une variante, une borne d'entrée et une borne de sortie de la barre de connexion électrique sont au niveau dudit premier côté du dissipateur thermique.

Dans une variante, le dissipateur thermique comprend un deuxième côté au niveau duquel lesdites deux faces opposées sont reliées, ledit deuxième côté étant opposé au premier côté. Ladite barre de connexion électrique s'étend le long dudit dissipateur thermique depuis le premier côté jusqu'au deuxième côté, puis du deuxième côté vers le premier côté.

Selon un mode de réalisation, la barre de connexion électrique comporte deux parties assemblées ensemble, la première partie venant contre une première desdites faces du dissipateur thermique et la deuxième partie venant contre la deuxième desdites faces du dissipateur thermique, de manière à entourer le dissipateur thermique.

Selon une variante, la première partie et la deuxième partie de la barre de connexion électrique sont assemblées ensemble au niveau du deuxième bord du dissipateur thermique.

Selon un mode de réalisation, la barre de connexion électrique est d'un seul tenant en entourant le dissipateur thermique.

Selon un mode de réalisation, la barre de connexion électrique comporte un revêtement entourant une barre de conduction électrique,
le revêtement comportant une ouverture venant en face d'une partie du dissipateur thermique, l'ouverture comportant un matériau isolant électrique de dissipation thermique de manière à améliorer le refroidissement de ladite barre de conduction électrique.

Selon un mode de réalisation, la barre de connexion électrique supporte au moins un composant électrique. Dans une variante, le composant électrique est un composant de filtrage CEM.

Dans une variante, le composant électrique se trouve en sandwich entre la barre de connexion électrique et le dissipateur thermique.

Selon un mode de réalisation, au moins une desdites faces du dissipateur thermique est configurée pour refroidir d'autres composants sur au moins une surface non couverte par la barre de connexion électrique.

Selon une variante, la première face du dissipateur thermique reçoit un module électronique de puissance et la deuxième face du dissipateur thermique reçoit un module capacitif au niveau de surfaces non couvertes par la barre de connexion électrique.

Selon une variante, le dissipateur thermique comprend au moins un canal de refroidissement configuré pour recevoir un fluide de refroidissement,
le canal de refroidissement se trouvant au moins en partie dans la zone non couverte par la barre de connexion électrique, et la partie du dissipateur thermique entourée par la barre de connexion électrique étant dépourvue de canal de refroidissement.

### PRÉSENTATION DES FIGURES

L'invention sera mieux comprise et d'autres détails, caractéristiques et avantages de l'invention apparaîtront à la lecture de la description suivante faite à titre d'exemple non limitatif en référence aux figures annexées.
La figure 1 illustre une vue en perspective d'un exemple d'un équipement électrique selon l'invention.
La figure 2 illustre une vue en perspective de l'équipement électrique de la figure 1, dans lequel la barre de connexion électrique est munie de composants.
La figure 3 illustre une vue en coupe de l'équipement électrique de la figure 2.
La figure 4 illustre une vue explosée de l'équipement électrique de la figure 2.
La figure 5 illustre une vue de détail d'une variante de l'équipement électrique de la figure 2.

### DESCRIPTION DÉTAILLÉE DE L'INVENTION

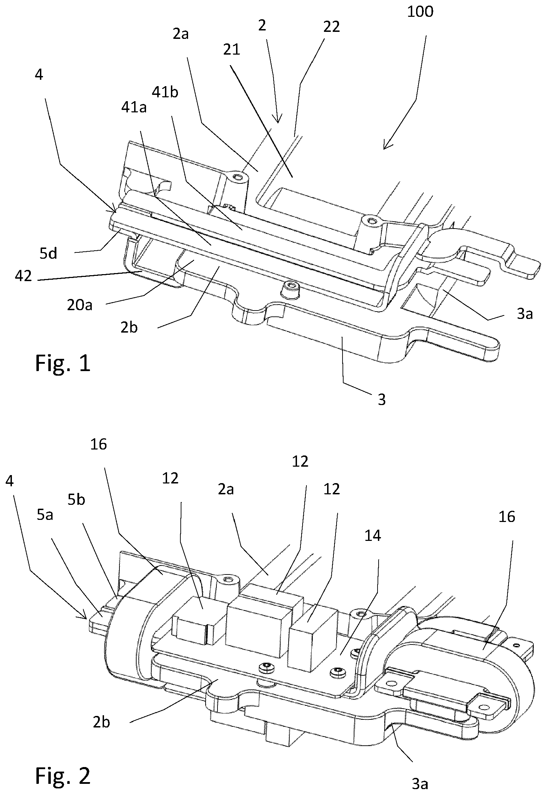

L'équipement électrique 100 tel qu'illustré par la figure 1 comporte un dissipateur thermique 2, qui comprend un volume interne délimité par au moins deux faces opposées 20a, 20b. Dans l'exemple illustré, une partie du dissipateur thermique 2 appelée partie principale 2a, peut comprendre un canal de refroidissement 21 configuré pour recevoir un fluide de refroidissement. Une autre partie du dissipateur thermique, appelée partie auxiliaire 2b, est alors dépourvue d'un canal de refroidissement. La partie auxiliaire 2b est notamment refroidie par conduction thermique depuis la partie auxiliaire 2b jusqu'à la partie principale 2a où la chaleur est drainée par le fluide de refroidissement circulant dans le canal de refroidissement 21. Autrement dit, la partie auxiliaire 2b forme une excroissance de matière depuis la partie principale 2a. En ne prévoyant pas de canal de refroidissement dans la partie auxiliaire 2b, on limite ainsi son encombrement et l'encombrement final de l'équipement électrique 100. Le dissipateur thermique 2 peut avoir une forme sensiblement rectangulaire. Cependant, la partie auxiliaire 2b pourrait recevoir un canal de refroidissement, ce qui augmenterait son encombrement mais améliorerait la dissipation thermique au niveau de la partie auxiliaire 2b. Mais une partie auxiliaire 2b dépourvue de canal de refroidissement est suffisante pour un refroidissement d'une barre de connexion électrique, notamment tel que décrit ci-après. La partie auxiliaire 2b pourrait être fait d'un matériau diffèrent de celui de la partie principale 2a. Notamment la partie auxiliaire 2b pourrait être en un matériau d'une conductivité thermique plus élevée que celle de la partie principale 2a. Par exemple la partie principale 2a est en aluminium et la partie auxiliaire 2b est en cuivre. Cependant le coût pourrait être sensiblement supérieure.

Les deux faces opposées 20a, 20b peuvent avoir un contour sensiblement identique. Elles peuvent se superposer de façon sensiblement parallèle. Les contours des deux faces opposées 20a, 20b sont notamment reliés par une paroi 3 tout au long des contours. Alternativement, les contours des deux faces opposées peuvent être reliés directement entre elles, notamment sans paroi 3. Pour un positionnement d'un composant ou pour le passage d'une connexion, ou autre, les faces opposées 20a, 20b peuvent comporter des échancrures, des ouvertures ou autres différences par rapport à l'autre face opposée 20a, 20b. L'équipement électrique comporte une barre de connexion électrique 4. La barre de connexion électrique 4 peut comprendre deux barres de conduction électrique 41a, 41b (ou « leadframe » en anglais), notamment une barre de conduction négative 41a et une barre de conduction positive 41b. Les barres de conduction électrique 41a, 41b sont notamment en métal, par exemple en cuivre. Elles forment des pièces rigides qui sont maintenues ensemble par un revêtement 42 en matériau isolant électrique, déposé par exemple par surmoulage. En figure 1, une partie du revêtement 42 n'est pas représentée afin de rendre visible les barres de conduction électrique 41a, 41b. Les barres de conduction électrique 41a, 41b connectent notamment des bornes de l'équipement électrique 100 avec une capacité de l'équipement électrique 100.

La barre de connexion électrique 4 vient en contact contre les deux faces opposées 20a, 20b du dissipateur thermique 2 de manière à être refroidie par le dissipateur thermique 2. Ainsi, la barre de connexion électrique 4 profite de deux faces du dissipateur thermique 2 pour être refroidie. L'intégration de la barre de connexion électrique 4 dans l'équipement électrique 100 est améliorée par rapport à l'art antérieur. Le refroidissement de la barre de connexion électrique 4 est amélioré tout en maîtrisant l'encombrement de l'équipement électrique 100. La barre de connexion électrique 4 s'étend en particulier le long des deux faces opposées 20a, 20b du dissipateur thermique 2 de manière à entourer le dissipateur thermique 2. La barre de connexion électrique 4 peut donc être refroidie sur toute sa longueur. Les surfaces de la barre de connexion électrique 4 qui sont refroidies sont donc augmentées par rapport à l'art antérieur. Le refroidissement de la barre de connexion électrique 4 est alors plus élevé, le risque d'endommagement par la chaleur diminue donc fortement. En outre en entourant le dissipateur thermique 2, la barre de connexion électrique 4 est intégrée avec le dissipateur thermique 2.

En particulier, la barre de connexion électrique 4 part d'un premier côté 3a du dissipateur thermique 2 ; s'étend le long de la partie auxiliaire 2b, notamment le long de la portion de la première face 20a comprise dans la partie auxiliaire 2b. La barre de connexion 4 rejoint ensuite la deuxième face 20b par un deuxième côté 3b du dissipateur thermique 2, et longe à nouveau la partie auxiliaire 2b, notamment le long de la portion de la deuxième face 20b comprise dans la partie auxiliaire 2b, pour revenir au premier côté 3a. Ainsi, la barre de connexion électrique 4 forme une boucle autour du dissipateur thermique 2, notamment autour de la partie auxiliaire 2b. En revenant au premier côté 3a, les raccordements électriques à la barre de connexion électrique 4, par exemple le raccordement à une borne de l'équipement électrique 100 ou le raccordement à une capacité de l'équipement électrique 100, peuvent être prévus d'un même côté 3a du dissipateur thermique 2. Notamment sur le plan industriel, lors de la fabrication de l'équipement électrique 100, cet agencement permet de raccorder la barre de connexion électrique 4 plus facilement. Les deux raccordements peuvent donc être réalisés depuis un même côté du dissipateur thermique 2, sans retournement de l'équipement électrique 100 ; ce qui permet d'économiser une étape de fabrication et du temps également. Des manipulations inutiles de l'équipement électrique 100 pendant l'assemblage sont donc évitées et/ou un contrôle qualité est donc facilité. En particulier, le deuxième côté 3b est opposé au premier côté 3a. Cependant, ce deuxième côté 3b pourrait être un côté du dissipateur thermique 2 qui est adjacent au premier côté 3a.

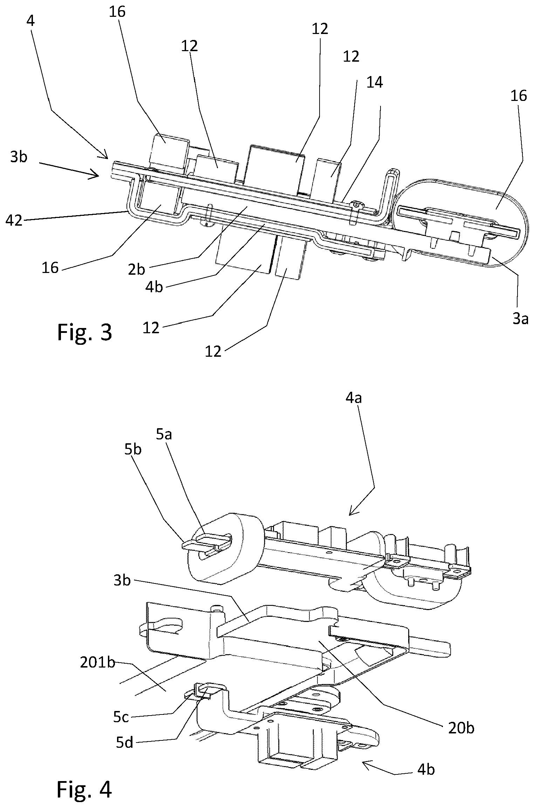

La barre de connexion 4 comporte notamment deux parties 4a, 4b assemblées ensemble de manière à entourer le dissipateur thermique 2. La première partie 4a vient contre la première face 20a du dissipateur thermique 2 ; et la deuxième partie 4b vient contre la deuxième face 20b du dissipateur thermique 2. Ainsi, l'assemblage de la barre de connexion électrique 4 autour du dissipateur thermique 2 peut se faire en plusieurs étapes. En particulier, la première partie 4a et la deuxième partie 4b de la barre de connexion électrique 4 sont assemblées ensemble au niveau du deuxième côté 3b du dissipateur thermique 2. Notamment, les barres de conduction électrique 41a, 41b comportent chacune une première partie venant contre la première face 20a et une deuxième partie venant contre la deuxième face 20b. Comme illustré par exemple en figure 4, des extrémités 5a, 5b des premières parties des barres de conduction électrique 41a, 41b viennent contre des extrémités respectives 5c, 5d des deuxièmes parties des barres de conduction électrique 41a, 41b. Ces extrémités 5a, 5b, 5c, 5d sont connectées par soudage, brasage, vissage ou tout autre moyen de fixation. L'agencement décrit précédemment permet un assemblage de la barre de connexion électrique 4 avec le dissipateur thermique 2 suivant un seul axe.

Alternativement, la barre de connexion 4 pourrait être d'un seul tenant en entourant le dissipateur thermique 2. Les barres de conduction électrique 41a, 41b sont alors chacune d'un seul tenant, et notamment s'étendent continûment de la première face 20a à la deuxième face 20b. Cette variante permet au contraire d'économiser des pièces, par exemple des pièces raccordant les première 4a et deuxième 4b parties de la barre de connexion électrique 4, et/ou des étapes de pré-assemblage. En outre, un assemblage éventuel dans un mauvais sens est évité.

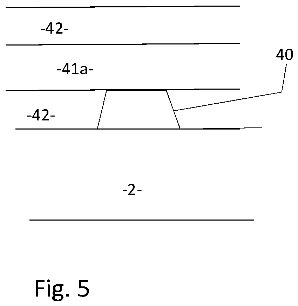

Comme par exemple illustré en figure 5, le revêtement 42 de la barre de connexion 4 peut comporter une ou plusieurs ouvertures 40 venant en face du dissipateur thermique 2. L'ouverture 40 met notamment à découvert une surface de la barre de conduction électrique 41a, 41b. Cette ouverture 40 est alors remplie avec un matériau isolant électrique, mais thermiquement conducteur qui agit de manière à améliorer le refroidissement de la barre de conduction électrique 41a, 41b. Le matériau peut être une graisse thermique ou un matériau souple, comme par exemple un « gap pad » ^{®} ou tout autre matériau aux caractéristiques duales d'isolation électrique et de conduction thermique.

Comme par exemple illustré en figures 2, 3 et 4, la barre de connexion électrique 4 peut supporter des composants 12, 16. Notamment des composants de filtrage 12 et des noyaux magnétiques 16, nécessaires au filtrage. Ces composants 12, 16 peuvent être assemblés sur une carte électronique 14, (en anglais « electronic board ») qui est elle-même montée sur la barre de connexion électrique 4, notamment sur le revêtement 42 de la barre de connexion électrique 4. La carte électronique 14 reçoit notamment des éléments électriques de petite taille, dont un assemblage direct sur la barre de connexion électrique 4 serait difficile. Le filtrage permet de diminuer le champ électromagnétique CEM lié au courant circulant dans la barre de connexion électrique 4 afin de protéger les composants de l'équipement électrique 100. D'autres composants peuvent être placés sur une autre carte électronique et reliés à la barre de connexion électrique 4 par des câbles, des nappes ou un connecteur rigide.

Alternativement, les composants 12, 16 peuvent être montés directement sur la barre de connexion électrique 4, sans intermédiaire de la carte électronique 14. Dans ce cas les composants 12, 16 peuvent être soudés, brasés ou fixés par toute autre méthode de fixation sur la barre de connexion électrique 4.

Notamment, la barre de connexion électrique 4 vient contre le dissipateur thermique 2 au niveau de la partie auxiliaire 2b du dissipateur thermique 2. La barre de connexion électrique 4 ne couvre qu'une zone sur le dissipateur thermique 2. De préférence, la barre de connexion électrique 4 ne couvre qu'une zone de la partie auxiliaire 2b du dissipateur thermique 2. Le reste du dissipateur thermique 2, notamment les portions des première 20a et deuxième 20b faces situées dans la partie principale 2a, peuvent recevoir d'autres composants pour les refroidir. Par exemple, en figure 1, une ouverture 22 dans la première face 20a du dissipateur thermique 2 est fermée par une plaque portant un module électronique de puissance. La plaque, en fermant l'ouverture 22 de la première face 20a contribue notamment à former le canal de refroidissement situé dans la partie principale 2a du dissipateur thermique 2. Par exemple comme illustré en figure 4, une portion 201b de la deuxième face 20b située dans la partie principale 2b peut recevoir une capacité qui sera refroidie par la partie principale 2a. Comme le module de puissance et la capacité émettent généralement beaucoup de chaleur par effet joule, il est avantageux de les agencer sur la partie principale 2a du dissipateur thermique.

Dans une variante non représentée, les composants 12, 16 peuvent se trouver en sandwich entre la barre de connexion électrique 4 et le dissipateur thermique 2, ce qui améliore le refroidissement des composants 12, 16. Dans ce cas particulier, la structure des faces 20a, 20b du dissipateur thermique 2 peut être adaptée à la taille des composants 12, 16. La surface du dissipateur thermique 2 contre laquelle viennent les composants 12,16 peut tenir compte des différentes hauteurs et formes des composants 12, 16 afin d'assurer leur refroidissement. Par exemple, en partant du dissipateur thermique 2, il y a d'abord une couche d'un matériau souple 42, isolant électriquement mais conducteur thermique, ensuite le composant 12, 16, suivi de la carte électronique 14 et de la barre de connexion électrique 4. Un tel agencement en sandwich permet en outre une tenue ferme des composants 12, 16. La dégradation par vibration est alors atténuée. La longévité de l'équipement électrique 100 est augmentée.

## Revendications

1. Équipement électrique (100) comportant :
- un dissipateur thermique (2) comprenant un volume interne délimité par au moins deux faces opposées (20a, 20b),
- une barre de connexion électrique (4),
**caractérisé en ce que** ladite barre de connexion électrique (4) s'étend le long et vient contre lesdites deux faces opposées (20a, 20b) du dissipateur thermique (2) de manière à être refroidie par ledit dissipateur thermique (2).

2. Équipement électrique (100) selon la revendication 1, dans lequel la barre de connexion électrique (4) s'étend le long des deux faces opposées (20a, 20b) de manière à entourer le dissipateur thermique (2).

3. Équipement électrique (100) selon la revendication 1 ou 2, dans lequel le dissipateur thermique (2) comprend un premier côté (3a) au niveau duquel lesdites deux faces opposées (20a, 20b) sont reliées, ladite barre de connexion électrique (4) s'étendant le long dudit dissipateur thermique (2) depuis le premier côté (3a) en revenant audit premier côté (3a).

4. Équipement électrique (100) selon la revendication précédente, dans lequel une borne d'entrée et une borne de sortie de ladite barre de connexion électrique (4) sont au niveau dudit premier côté (3a) du dissipateur thermique (2).

5. Équipement électrique (100) selon les revendications 3 ou 4, dans lequel ledit dissipateur thermique (2) comprend un deuxième côté (3b) au niveau duquel lesdites deux faces opposées (20a, 20b) sont reliées, ledit deuxième côté (3b) étant opposé au premier côté (3a),
et dans lequel ladite barre de connexion électrique (4) s'étend le long dudit dissipateur thermique (2) depuis le premier côté (3a) jusqu'au deuxième côté (3b), puis du deuxième côté (3b) vers le premier côté (3a).

6. Équipement électrique (100) selon l'une des revendications précédentes, dans lequel ladite barre de connexion électrique (4) comporte deux parties (4a, 4b) assemblées ensemble, la première partie (4a) venant contre une première desdites faces (20a) du dissipateur thermique (2) et la deuxième partie (4b) venant contre la deuxième desdites faces (20b) du dissipateur thermique (2), de manière à entourer ledit dissipateur thermique (2).

7. Équipement électrique (100) selon les revendications 5 et 6, dans lequel la première partie (4a) et la deuxième partie (4b) de la barre de connexion électrique (4) sont assemblées ensemble au niveau du deuxième côté (3b) du dissipateur thermique (2).

8. Équipement électrique (100) selon l'une des revendications 1 à 5, dans lequel ladite barre de connexion électrique (4) est d'un seul tenant en entourant le dissipateur thermique (2).

9. Équipement électrique (100) selon l'une des revendications précédentes, dans lequel la barre de connexion électrique (4) comporte un revêtement (42) entourant une barre de conduction électrique (41a, 41b),
ledit revêtement (42) comportant une ouverture venant en face d'une partie du dissipateur thermique (2), ladite ouverture (40) comportant un matériau isolant électrique de dissipation thermique de manière à améliorer le refroidissement de ladite barre de conduction électrique (41a, 41b).

10. Équipement électrique (100) selon l'une des revendications précédentes, dans lequel au moins une desdites faces opposées (20a, 20b) du dissipateur thermique (2) est configurée pour refroidir d'autres composants sur au moins une surface non couverte par ladite barre de connexion électrique (4).

11. Équipement électrique (100) selon la revendication 10, dans lequel ledit dissipateur thermique (2) comprend au moins un canal de refroidissement (21) configuré pour recevoir un fluide de refroidissement,
ledit canal de refroidissement (21) se trouvant au moins en partie dans la zone non couverte par ladite barre de connexion électrique (4), et la partie du dissipateur thermique (2) entourée par la barre de connexion électrique (4) étant dépourvue de canal de refroidissement.

## Patentansprüche

1. Elektrisches Gerät (100), umfassend:
- einen Kühlkörper (2), der ein Innenvolumen aufweist, das durch mindestens zwei entgegengesetzte Seiten (20a, 20b) begrenzt wird,
- eine elektrische Anschlussschiene (4),
**dadurch gekennzeichnet, dass** sich die elektrische Anschlussschiene (4) entlang der beiden entgegengesetzten Seiten (20a, 20b) des Kühlkörpers (2) erstreckt und daran anliegt, so dass sie durch den Kühlkörper (2) gekühlt wird.

2. Elektrisches Gerät (100) nach Anspruch 1, bei dem sich die elektrische Anschlussschiene (4) entlang der beiden entgegengesetzten Seiten (20a, 20b) so erstreckt, dass sie den Kühlkörper (2) umgibt.

3. Elektrisches Gerät (100) nach Anspruch 1 oder 2, bei dem der Kühlkörper (2) eine erste Schmalseite (3a) aufweist, an der die beiden entgegengesetzten Flächen (20a, 20b) verbunden sind, wobei sich die elektrische Anschlussschiene (4) entlang des Kühlkörpers (2) von der ersten Schmalseite (3a) aus und zurück zu der ersten Schmalseite (3a) erstreckt.

4. Elektrisches Gerät (100) nach dem vorhergehenden Anspruch, bei dem eine Eingangsklemme und eine Ausgangsklemme der elektrischen Anschlussschiene (4) an der ersten Schmalseite (3a) des Kühlkörpers (2) sind.

5. Elektrisches Gerät (100) nach den Ansprüchen 3 oder 4, bei dem der Kühlkörper (2) eine zweite Schmalseite (3b) aufweist, an der die beiden entgegengesetzten Seiten (20a, 20b) verbunden sind, wobei die zweite Schmalseite (3b) zu der ersten Schmalseite (3a) entgegengesetzt ist, und bei dem sich die elektrische Anschlussschiene (4) entlang des Kühlkörpers (2) von der ersten Schmalseite (3a) aus bis zu der zweiten Schmalseite (3b), dann von der zweiten Schmalseite (3b) zu der ersten Schmalseite (3a) hin erstreckt.

6. Elektrisches Gerät (100) nach einem der vorhergehenden Ansprüche, bei dem die elektrische Anschlussschiene (4) zwei zusammengefügte Teile (4a, 4b) umfasst, wobei der erste Teil (4a) an einer ersten der Seiten (20a) des Kühlkörpers (2) anliegt und wobei der zweite Teil (4b) an der zweiten der Seiten (20b) des Kühlkörpers (2) anliegt, so dass sie den Kühlkörper (2) umgeben.

7. Elektrisches Gerät (100) nach den Ansprüchen 5 und 6, bei dem der erste Teil (4a) und der zweite Teil (4b) der elektrischen Anschlussschiene (4) an der zweiten Schmalseite (3b) des Kühlkörpers (2) zusammengefügt sind.

8. Elektrisches Gerät (100) nach einem der Ansprüche 1 bis 5, bei dem die elektrische Anschlussschiene (4) einstückig ist, wobei sie den Kühlkörper (2) umgibt.

9. Elektrisches Gerät (100) nach einem der vorhergehenden Ansprüche, bei dem die elektrische Anschlussschiene (4) einen Überzug (42) umfasst, der eine elektrische Anschlussschiene (41a, 41b) umgibt,
wobei der Überzug (42) eine Öffnung umfasst, die einem Teil des Kühlkörpers (2) gegenüber liegt, wobei die Öffnung (40) ein elektrisches Isoliermaterial zur Wärmeableitung umfasst, so dass die Kühlung der elektrischen Anschlussschiene (41a, 41b) verbessert wird.

10. Elektrisches Gerät (100) nach einem der vorhergehenden Ansprüche, bei dem mindestens eine der entgegengesetzten Seiten (20a, 20b) des Kühlkörpers (2) dazu ausgestaltet ist, weitere Bauteile auf mindestens einer Oberfläche zu kühlen, die nicht von der elektrischen Anschlussschiene (4) bedeckt wird.

11. Elektrisches Gerät (100) nach Anspruch 10, bei dem der Kühlkörper (2) mindestens einen Kühlkanal (21) aufweist, der dazu ausgestaltet ist, ein Kühlmedium aufzunehmen,
wobei sich der Kühlkanal (21) mindestens zum Teil in dem nicht von der elektrischen Anschlussschiene (4) bedeckten Bereich befindet und wobei der von der elektrischen Anschlussschiene (4) umgebene Teil des Kühlkörpers (2) keinen Kühlkanal aufweist.

## Claims

1. Electrical device (100) having:
- a heat sink (2) comprising an internal volume delimited by at least two opposite faces (20a, 20b),
- a busbar (4),
**characterized in that** said busbar (4) extends along and butts against said two opposite faces (20a, 20b) of the heat sink (2) so as to be cooled by said heat sink (2).

2. Electrical device (100) according to Claim 1, wherein the busbar (4) extends along the two opposite faces (20a, 20b) so as to surround the heat sink (2).

3. Electrical device (100) according to Claim 1 or 2, wherein the heat sink (2) comprises a first side (3a) at which said two opposite faces (20a, 20b) are connected, said busbar (4) extending along said heat sink (2) from the first side (3a), returning to said first side (3a).

4. Electrical device (100) according to the preceding claim, wherein an input terminal and an output terminal of said busbar (4) are at said first side (3a) of the heat sink (2).

5. Electrical device (100) according to Claim 3 or 4, wherein said heat sink (2) comprises a second side (3b) at which said two opposite faces (20a, 20b) are connected, said second side (3b) being opposite the first side (3a),
and wherein said busbar (4) extends along said heat sink (2) from the first side (3a) as far as the second side (3b), then from the second side (3b) towards the first side (3a).

6. Electrical device (100) according to one of the preceding claims, wherein said busbar (4) has two parts (4a, 4b) that are joined together, the first part (4a) butting against a first of said faces (20a) of the heat sink (2) and the second part (4b) butting against the second of said faces (20b) of the heat sink (2), so as to surround said heat sink (2).

7. Electrical device (100) according to Claims 5 and 6, wherein the first part (4a) and the second part (4b) of the busbar (4) are joined together at the second side (3b) of the heat sink (2).

8. Electrical device (100) according to one of Claims 1 to 5, wherein said busbar (4) is in one piece, surrounding the heat sink (2).

9. Electrical device (100) according to one of the preceding claims, wherein the busbar (4) has a coating (42) surrounding a leadframe (41a, 41b),
said coating (42) having an opening facing a part of the heat sink (2), said opening (40) having an electrically insulating heat sink material so as to improve the cooling of said leadframe (41a, 41b).

10. Electrical device (100) according to one of the preceding claims, wherein at least one of said opposite faces (20a, 20b) of the heat sink (2) is configured to cool other components on at least one surface that is not covered by said busbar (4).

11. Electrical device (100) according to Claim 10, wherein said heat sink (2) comprises at least one cooling channel (21) configured to receive a cooling fluid,
said cooling channel (21) being at least in part in the zone that is not covered by said busbar (4), and the part of the heat sink (2) that is surrounded by the busbar (4) being devoid of cooling channel.
